# EUROPEAN PATENT SPECIFICATION

(11) **EP 2 787 112 B1**
(45) Date of publication and mention of the grant of the patent: **09.02.2022**
(21) Application number: 14162354.6
(22) Date of filing: 28.03.2014
(51) Int. Cl.: D06F 34/32

(54) **Control method of a control panel of a clothes treating apparatus**
Steuerverfahren einer Steuertafel einer Kleiderbehandlungsvorrichtung
Procédé de commande d'un pannau de commande d'un appareil de traitement des vêtements

(30) Priority: 04.04.2013 KR 20130037105
(43) Date of publication of application: 08.10.2014
(73) Proprietor: LG Electronics Inc., Seoul 150-721 (KR)
(72) Inventor: Park, Youngbae, Seoul 153-802 (KR); Jung, Noran, Seoul 153-802 (KR); Kim, Jimaeng, Seoul 153-802 (KR); Jang, Yongwoon, Seoul 153-802 (KR)
(74) Representative: Vossius & Partner Patentanwälte Rechtsanwälte mbB

(56) References cited:
- DE-A1-102008 030 365
- JP-A- H10 127 977
- US-A- 5 698 826
- US-A1- 2002 116 959
- US-A1- 2003 019 734
- US-A1- 2004 118 872
- US-A1- 2010 156 317
- US-A1- 2013 057 165

## Description

### BACKGROUND OF THE INVENTION

### Field of the Invention

The present invention relates to a control panel provided on an apparatus to control the apparatus, and more particularly, to a control panel of an electric home appliance, particularly, a clothes treating apparatus, a control method thereof, a clothes treating apparatus having the control panel, and a control method thereof.

### Discussion of the Related Art

In general, a clothes treating apparatus is an apparatus which removes various contaminants attached to clothes and bedclothes (a target to be washed) using emulsion action of detergent and frictional force and impulsive force of a water current due to rotation of a pulsator (or a drum).

Further, clothes treating apparatuses include an electric home appliance capable of drying laundry and an electric home appliance capable of washing and drying laundry as well as an electric home appliance capable of washing laundry.

A conventional clothes treating apparatus includes a control panel provided on a cabinet forming the external appearance of the clothes treating apparatus so as to input a control command, such as a washing course.

The control panel includes input units including buttons (having physical shapes) to supply power, to select one of courses, and to give a command to execute and stop the selected course, and a display unit to display the control command input through the input unit and/or a washing process of laundry to be washed.

### SUMMARY OF THE INVENTION

Accordingly, the present invention is directed to a control panel, a control method thereof, and a clothes treating apparatus having the same that substantially obviate one or more problems due to limitations and disadvantages of the related art.

US 2010/156317 A1 relates to a light-emitting element driving circuit including a PWM signal output circuit configured to output a plurality of PWM signals each having one logic level whose duty ratio corresponds to gradation data and each corresponding to each of a plurality of light-emitting elements, on the basis of the gradation data indicating brightness of each of the plurality of light-emitting elements.

JP H10 127977 A relates to a control circuit that controls a display driving circuit so that one part of light emitting diodes as the light emitting elements of a display are turned on with prescribed power on an initial stage just after a power source switch is turned on.

US 5 698 826 A relates to an appliance control panel having selective backlighting including a selection area that is normally visible to the operator including an "OPTIONS" switch.

An object of the present invention is to provide a control panel through which a control command may be input using bioelectric currents of a user and a clothes treating apparatus having the control panel, and a control method thereof.

Another object of the present invention is to provide a control panel which prevents a clothes treating apparatus from being operated against user intention even if bioelectric currents are input through two or more input units, a clothes treating apparatus having the control panel, and a control method thereof.

Another object of the present invention is to provide a control panel which may control brightness of light emission units through a time during which current is supplied, a clothes treating apparatus having the control panel, and a control method thereof.

Another object of the present invention is to provide a control panel in which a plurality of light emission units emits light in various patterns when a power supply signal is input to a clothes treating apparatus, a clothes treating apparatus having the control panel, and a control method thereof.

Another object of the present invention is to provide a control panel in which a user may clearly recognize selection of a course displayed by a target light emission unit through a difference of brightness levels between the target light emission unit and background light emission units, a clothes treating apparatus having the control panel, and a control method thereof.

Another object of the present invention is to provide a control panel in which a user may clearly recognize whether or not a control command displayed by light discharge units is preset and whether or not the control command is selected by varying brightness levels of light emission units emitting light toward the light discharge units when power is supplied, a clothes treating apparatus having the control panel, and a control method thereof.

Yet another object of the present invention is to provide a control panel which may implement various initial light emitting patterns of light emission units after power is supplied and thus improve product satisfaction, a clothes treating apparatus having the control panel, and a control method thereof.

Additional advantages, objects, and features of the invention will be set forth in part in the description which follows and in part will become apparent to those having ordinary skill in the art upon examination of the following or may be learned from practice of the invention. The objectives and other advantages of the invention may be realized and attained by the structure particularly pointed out in the written description and claims hereof as well as the appended drawings.

The above objects of the present invention are achieved by the features defined in the independent claim. The dependent claims relate to further aspects of the invention.

To achieve these objects and other advantages and in accordance with the purpose of the invention, as embodied and broadly described herein, a control panel includes a panel body forming the external appearance of the control panel, light discharge units provided on the panel body in the form of characters, figures, or marks recognizable by a user, light emission units located under the light discharge units and emitting light toward the light discharge units, and a control unit controlling brightness of the light emission units by adjusting supply times of current supplied to the light emission units.

The control unit may include a controller, a first circuit (scan lines) to which current is supplied, a timer connecting the scan lines to the controller and supplying current of a regular intensity to the first circuit according to a predetermined cycle, and a second circuit (data lines) supplying current supplied from the first cycle to the light emission units based on a duty cycle provided by the controller.

In another aspect of the present invention, a control method of a control panel of a clothes treating apparatus, which has a panel body forming the external appearance of the control panel, a plurality of light discharge units provided on the panel body, and a plurality of light emission units located under the plurality of light discharge units and emitting light toward the plurality of light discharge units, includes inputting a power supply command to the clothes treating apparatus through a power input unit, and controlling a target light emission unit so as to emit light more brightly than background light emission units by dividing a duty cycle of current supplied to each of the plurality of light emission units into a duty cycle of the target light emission unit and a duty cycle of the background light emission units, when power is input.

That is, the background light emission units as well as the target light emission unit may emit light but be controlled so as to have brightness of different levels.

Current of the same intensity may be supplied to the plurality of light emission units and the duty cycle of the target light emission unit may be controlled to be greater than the duty cycle of the background light emission units. That is, the intensity of current may not be varied but the cycle in which current is applied may be varied and therethrough, a difference of brightness levels may be generated.

The duty cycle of the target light emission unit may be 4 times the duty cycle of the background light emission units. For example, the duty cycle of the target light emission unit may be 1 ms/8 ms (1second =1000 ms) and the duty cycle of the background light emission unit may be 0.5 ms/16 ms.

The plurality of light emission units are provided in a matrix, respective light emission unit columns receive current of the same intensity in a regular cycle through scan lines, and a duty cycle in which a specific light emission unit receives current from a specific scan line may be controlled through data lines.

In order to control the plurality of light emission units, a timer is provided.

In more detail, supply times of current supplied from the scan lines are controlled through a timer. Further, current is not be supplied simultaneously to a plurality of scan lines and may be supplied to the respective scan lines according to a designated cycle through the timer.

The timer may supply current to the scan lines according to a plurality of current supply times. The plurality of current supply times may include 1 ms, 875 *µ*s, 750 *µ*s, 625 *µ*s, 500 *µ*s, 375 *µ*s, 250 *µ*s, and 125 *µ*s. Therefore, as the current supply time increases, brightness of the light emission units may increase. Therefore, 8 current supply times may be selected and thus, 8 brightness levels may be implemented.

The control panel may include a controller operating the clothes treating apparatus according to a control command input through input units, and the controller may transmit a signal, connecting a specific light emission unit to a specific scan line, to the respective light emission units through the data lines.

The controller may transmit a signal, connecting the target light emission unit to the scan line and separating the target light emission unit from the scan line in the duty cycle of the target light emission unit, to the target light emission unit through the data lines, and transmit a signal, connecting the background light emission units to the scan line and separating the background light emission units from the scan line in the duty cycle of the background light emission units, to the background light emission units except for the target light emission unit through the data lines.

The target light emission unit may be preset. Therefore, a user may easily recognize a preset control command through the light discharge unit corresponding to the preset target light emission unit. For example, after power is applied, the user may easily recognize a preset control command through the control command more brightly displayed by the target light emission unit.

The target light emission unit is set through selection of input units by a user. The set target light emission unit may emit light more brightly than the background light emission units. Therefore, a user may easily recognize that a control command corresponding to the target light emission unit is set.

The target light emission unit may be controlled so as to emit light at the brightest level and the background light emission units may be controlled so as to emit light at the darkest level. Therefore, a user may intuitively easily recognize a difference between the target light emission unit and the background light emission units.

The control panel may include the panel body of an achromatic color, such as black. That is, the surface of the panel body may be coated or painted with an achromatic color, such as black. Therefore, if the light emission units do not emit light, for example, if power is not applied, it may be difficult for a user to recognize marks, characters, or figures displayed on the light discharge units. This may cause the user to recognize the panel body as a black display. Particularly, the light discharge units may be recognized as the black display. Therefore, the control panel may have a excellent appearance and a minimal design.

Further, if power is applied, marks, characters, or figures displayed on the light discharge units may be recognized. A plurality of control commands may be displayed on the light discharge units. Therefore, the plurality of control commands may be clearly divided into a selected command and other commands. For this purpose, the background light emission units as well as the target light emission unit may be controlled so as to emit light.

When power is input, the background light emission units may be controlled so as to emit light at the darkest level and the target light emission unit set through selection of input units by a user may be controlled so as to emit light at the brightest level. Therefore, control commands corresponding to the background light emission units as well as a control command corresponding to the target light emission unit may be easily recognized. Of course, a user may more clearly recognize a selected control command and selectable control commands through a difference of brightness levels.

When power is input, the target light emission unit and the background light emission units may be gradually brightened in stages and then, the target light emission unit may maintain light emission at the brightest level and the background light emission units may be gradually darkened and maintain light emission at the darkest level. Through such control of the light emission units, a control panel which may provide amusement to a user rather than a control panel to simply display and select control commands may be provided.

When power is input, the target light emission unit and the background light emission units may be brightened in the state of the brightest level and then, the target light emission unit may maintain light emission at the brightest level and the background light emission units may be gradually darkened and maintain light emission at the darkest level. Through such control of the light emission units, a control panel which may provide amusement to a user rather than a control panel to simply display and select control commands may be provided.

The plurality of light discharge units may display control commands selectable by a user through input units on the panel body, and the light emission unit corresponding to a control command selected through the input units may be controlled in the duty cycle of the target light emission unit. Therefore, a user may more clearly recognize a control command selected through the input units.

In another aspect of the present invention, a control panel of a clothes treating apparatus includes a panel body forming the external appearance of the control panel, light discharge units provided on the panel body in the form of characters, figures, or marks recognizable by a user, light emission units located under the light discharge units and emitting light toward the light discharge units, and a control unit controlling brightness of the light emission units, wherein the control unit controls a target light emission unit so as to emit light more brightly than background light emission units by dividing a duty cycle of current supplied to each of the light emission units into a duty cycle of the target light emission unit and a duty cycle of the background light emission units.

The control unit includes a controller, scan lines to which current is supplied, a timer connecting the scan lines to the controller and supplying current of a regular intensity to the scan lines according to a predetermined cycle, and data lines supplying current supplied from the scan lines to the light emission units based on a duty cycle provided by the controller.

The light emission units are provided in a matrix, respective light emission unit columns receive current of the same intensity in a regular cycle through scan lines, and a duty cycle in which a specific light emission unit receives current from a specific scan line may be controlled through data lines.

It is to be understood that both the foregoing general description and the following detailed description of the present invention are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this application, illustrate embodiment(s) of the invention and together with the description serve to explain the principle of the invention. In the drawings:
FIGs. 1 and 2 are views illustrating a clothes treating apparatus having a control panel in accordance with one embodiment of the present invention;
FIG. 3 is an exploded perspective view of the control panel in accordance with the embodiment of the present invention;
FIGs. 4(a) to 4(c) are a block diagram of a control unit provided on the control panel shown in FIG. 3, a graph of current supply cycles, and a graph of current supply times;
FIGs. 5(a) and 5(b) are views illustrating an operating process of the control panel shown in FIG. 3 in accordance with one embodiment of the present invention;
FIGs. 6A(a) to 6B(b) are views illustrating an operating process of the control panel shown in FIG. 3 in accordance with another embodiment of the present invention;
FIGs. 7A(a) to 7B are views illustrating an operating process of the control panel shown in FIG. 3 in accordance with another embodiment of the present invention; and
FIGs. 8A(a) to 8C are views illustrating an operating process of the control panel shown in FIG. 3 in accordance with yet another embodiment of the present invention.

### DETAILED DESCRIPTION OF THE INVENTION

Reference will now be made in detail to the preferred embodiments of the present invention, examples of which are illustrated in the accompanying drawings.

All terms in the specification without special definitions have general meanings of the terms understood by those skilled in the art and, if a term used in the specification collides with the general meaning of the term, the definition of the term used in the specification is employed.

The configuration or control method of an apparatus which will be stated below has been made only for better understanding of the invention. Throughout the specification, the same or similar elements are denoted by the same reference numerals even though they are depicted in different drawings.

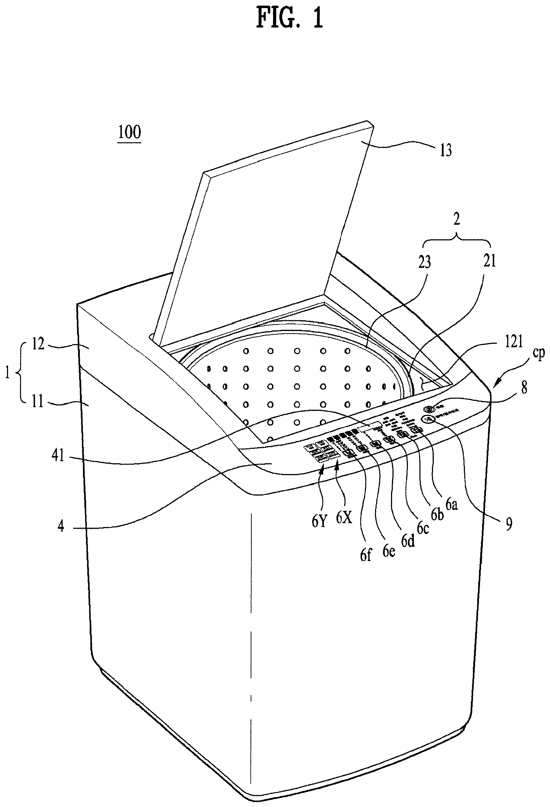

As exemplarily shown in FIG. 1, a clothes treating apparatus 100 may include a cabinet 1, a clothes receipt unit 2 provided within the cabinet 1 to receive clothes, and a control panel CP provided on the cabinet 1 so that a user may input a control command to the clothes treating apparatus 100 through the control panel CP.

The cabinet 1 may include a cabinet body 11 having a hexahedral shape, the upper surface of which is opened, and a cover 12 provided on the opened surface of the cabinet body 11.

An inlet 121 is provided on the cover 12 so that a user may put clothes into or withdraw clothes from the clothes receipt unit 2 through the inlet 121. The inlet 121 may be opened and closed by a door 13 rotatably combined with the cover 12.

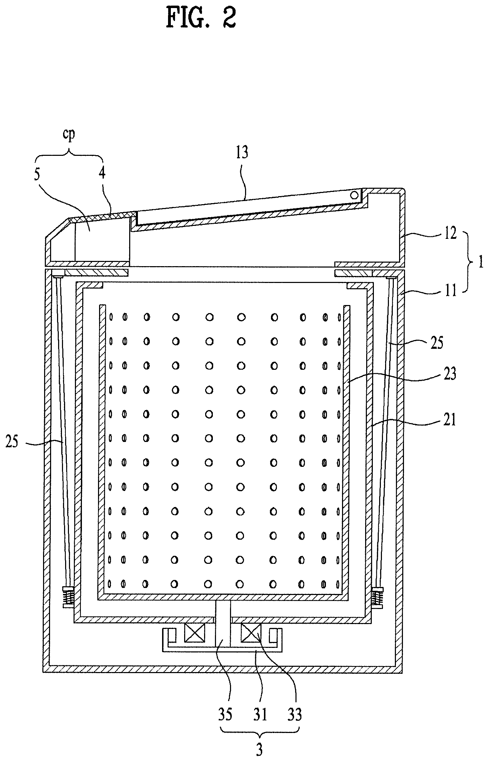

As exemplarily shown in FIG. 2, the clothes receipt unit 2 may include a tub (or outer tub) 21 provided within the cabinet 1 and storing wash water, and a drum (or inner tub) 23 rotatably provided within the tub 21 and receiving clothes.

The tub 21 may be fixed to the inside of the cabinet 1 by tub support units 25 connecting the inner circumferential surface of the cabinet 1 and the outer circumferential surface of the tub 21, and the tub support units 25 may be provided as structures (springs or dampers) capable of absorbing vibration generated on the tub 21.

The tub 21 may receive wash water supplied through a water supply unit (not shown) and wash water in the tub 21 may be discharged to the outside of the tub 21 through a drain unit (not shown).

The water supply unit (not shown) may include water supply hoses (not shown) connecting a water supply source (not shown) provided at the outside of the clothes treating apparatus 100 to the tub 21, and water supply valves (not shown) opening and closing the water supply hoses under the control of a control unit.

The drain unit (not shown) may include a drain hose (not shown) communicating the inside of the tub 21 with the outside of the cabinet 1, and a drain pump (not shown) provided in the drain hose.

A plurality of through holes, through which wash water stored in the tub 21 is introduced into the drum 23 and wash water in the drum 23 is discharged to the tub 21, is provided on the drum 23 and the drum 23 is rotated by a driving unit 3, such as a motor.

The driving unit 3 may include a stator 33 fixed to the outside of the tub 21, a rotor 31 located at the outside of the tub 21 and rotated by electromagnetic interaction with the stator 22, and a rotary shaft 35 connecting the rotor 31 to the drum 23.

In this case, the rotary shaft 35 passes through the bottom surface of the tub 21 and is fixed to the bottom surface of the drum 23, and a bearing assembly which prevents leakage of wash water in the tub 21 and rotatably supports the rotary shaft 35 may be provided on the tub 21.

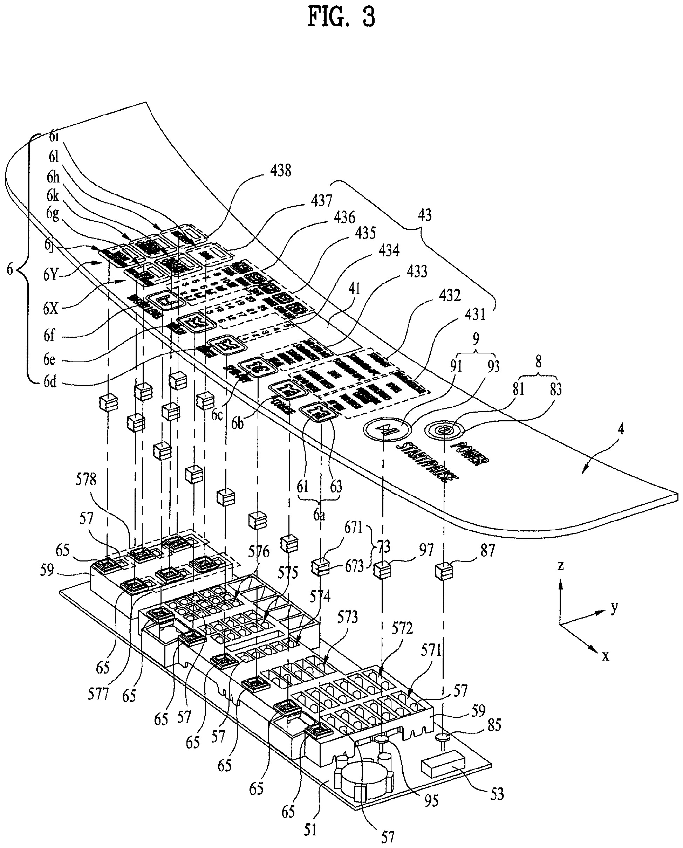

As exemplarily shown in FIG. 3, the control panel CP may include a panel body 4 provided on the surface of the cabinet 1 (i.e., the upper surface or the front surface of the cover 12), a control unit 5 fixed to the inside of the cabinet 1 and located under the panel body 4, and input units 6 transmitting a control command input by a user to the control unit 5.

The panel body 4 may be provided as a plate and include a transparent window 41 and light discharge units 43.

The panel body 4 may be inserted into a hole formed through the body 12 so as to be coplanar with the surface of the cover 12, or be provided by forming the transparent window 41 and the light discharge units 43 on the surface of the cover 12.

The transparent window 41 may be provided in various forms so that a user may confirm an object or displayed information located under the panel body 4 and be provided by forming a part of the panel body 4 of a transparent material.

The light discharge units 43 are provided on the surface of the panel body 4 so that light emitted from light emission units 57, which will be described later, may pass through the panel body 4. The light discharge units 43 may be provided in the form of characters, figures, or marks recognizable by a user.

If the light discharge units 43 are provided in the form of characters, figures, or marks recognizable by a user, the light discharge units 43 may function as a control command display unit to display control commands (a course, a supplied water amount, a drum rotation time, a supplied water temperature, a rotational speed of the drum, etc.) which are selectable by the user through the input units 6, on the panel body 4. Therefore, the user may clearly recognize control commands, displayed by the light discharge units 43, by light emitted from the light emission units 57.

The light discharge units 431 to 438 may not only serve to display control commands selectable by the user among control commands (a washing course, a drying course, etc.) executable by the clothes treating apparatus 100 on the panel body 4 but also serve to display control commands changeable by the user among control commands (a supplied water amount, a drum rotation time, a supplied water temperature, a rotational speed of the drum, etc.) preset in a specific course.

However, the light discharge units 43 may execute the above-described functions while the light emission units 57, which will be described later, emit light. That is, while the light emission units 57 emit light, display and selection of control commands may be possible.

The surface of the panel body 4 may be coated (or painted) with a material of an achromatic color or a chromatic color. Such coating or painting may be carried out in remaining regions except for regions in which characters or marks to be displayed through the light discharge units 43 are located, among regions of the panel body 4.

Particularly, if the panel body 4 is coated (or painted) with a material of an achromatic color, such as black, a user may not recognize the light discharge units 43 on the panel body 4 unless the light emission units 57 emit light. The inside of the control panel CP maintains a dark state and thereby, the user may feel compactness and refinement in design of the control panel CP.

That is, when the light emission units 57 do not emit light, the entirety of the panel body 4 as well as characters or marks on the light discharge units 43 may be expressed in black. That is, the entirety of the panel body 4 may be recognized as a black display panel. However, when the light emission units 57 emit light, the user may easily recognize characters or marks on the light discharge units 43.

The light discharge units 43 may be provided in the same number as the number of the input units 6, and be provided to form the same number of columns as the number of the input units 6. Further, the column corresponding to one input unit 6 may have a plurality of light discharge units 43.

FIG. 3 exemplarily illustrates the case that some of the light discharge units 43 are provided to form the same number of columns as the number of the input units 6 and the remainder of the light discharge units 43 are provided in the same number as the number of the input units 6.

That is, FIG. 3 exemplarily illustrates the control panel CP including six input units 6a to 6f provided in the length direction (in the X-axis direction) of the panel body 4 and two input unit columns, i.e., a first input unit column 6X and a second input unit column 6Y, provided in the height direction (in the Y-axis direction) of the panel body 4. Therefore, a plurality of light discharge units 43 may correspond to one input unit, i.e., one of the input units 6a to 6f, and one light discharge unit 43 may correspond to each of one input unit, i.e., one of the input units 6i to 61.

In this case, the light discharge units 43 include eight light discharge unit columns, i.e., a first light discharge unit column 431, a second light discharge unit column 432, a third light discharge unit column 433, a fourth light discharge unit column 434, a fifth light discharge unit column 435, a sixth light discharge unit column 436, a seventh light discharge unit column 437, and an eighth light discharge unit column 438.

The above-described number of light discharge unit columns is only one example and may thus be increased or decreased as needed. Hereinafter, for convenience of description, a control panel CP including eight light discharge unit columns will be described.

The control unit 5 may include a PCB 51 including a controller 53 operating the clothes treating apparatus 100 according to control commands input through the input units 6, a display unit 55 fixed to the PCB 51, controlled by the controller 53, and located under the transparent window 41, and light emission units 57 (LEDs, etc.) fixed to the PCB 51 and located under the light discharge units 43.

The display unit 55 serves to display operation information of the clothes treating apparatus 100. For example, the operation information may be information related to a course selected by a user, such as a time set in the course (a washing course, a drying course, etc.) selected by the user through the input units 6 and a residual time of the course selected by the user.

The light emission units 57 serve to emit light toward the light discharge units 43 from below so that a user may easily recognize characters, figures, or marks displayed by the light discharge units 43.

The number of the light emission units 57 may be the same as the number of the light discharge units 43. That is, one light emission unit 57 and one light discharge unit 43 may correspond to each other one-to-one.

Therefore, the light emission units 57 form the same number of columns as the number of the columns formed by the light discharge units 43. If the light discharge units 43 form eight columns 431 to 438, the light emission units 57 may form eight light emission unit columns, i.e., a first light emission unit column 571, a second light emission unit column 572, a third light emission unit column 573, a fourth light emission unit column 574, a fifth light emission unit column 575, a sixth light emission unit column 576, a seventh light emission unit column 577, and an eighth light emission unit column 578.

However, if the length of the light discharge units 43 (the length of the light discharge units 43 in the X-axis direction) or the height of the light discharge units 43 (the length of the light discharge units 43 in the Y-axis direction) is long, two or more light emission units 57 may be provided under one light discharge unit 43. FIG. 3 exemplarily illustrates two light emission units 57 as being provided under each of the light discharge units 43 corresponding to course input units 6a and 6b and one light emission unit 57 as being provided under each of the light discharge units 43 corresponding to a spin-drying input unit 6c.

In this case, the light emission units 57 may be provided to form the same number of columns as the number of the input units 6a to 6f. The reason for this is to control one light emission unit column 571, 572, 575, or 576 through one input unit 6a, 6b, 6e, or 6f.

Further, the light emission units 57 may be supported by light emission unit housings 59 fixed to the PCB 51.

The light emission unit housing 59 may include a plurality of reception holes 591 formed through the light emission unit housing 59 and surrounding the outer circumferential surfaces of the light emission units 57. The reception holes 591 may be extended from the PCB 51 to a height equal to or higher than the upper ends of the light emission units 57.

When the light emission units 57 are inserted into the reception holes 591 and combined with the PCB 51, light emitted from a specific light emission unit 57 may be supplied only to the light discharge unit 43 located above the specific light emission unit 57, thus improving visibility.

That is, discharge of light to light discharge units 43 other than the light discharge unit 43 located above the light emission unit 57 emitting such light may be minimized.

The input units 6 may be eight input units 6 provided in the length direction of the panel body 4 (in the X-axis direction).

However, in order to show that the control panel CP is deformable to have various types in design through arrangement of the input units 6, FIG. 3 exemplarily illustrates the case that six input units 6a to 6f are provided in the length direction of the panel body 4 and two input unit columns 6X and 6Y are provided in the height direction of the panel body 4 (in the Y-axis direction).

In this case, the first input unit column 6X may be formed by two or more input units 6g, 6h, and 6i arranged in the height direction of the panel body 4, and the second input unit column 6Y may be formed by two or more input units 6j, 6k, and 61 arranged in the height direction of the panel body 4.

Hereinafter, for convenience of description, one embodiment of the present invention will be described based on the control panel CP including six input units 6a to 6f provided in the length direction of the panel body 4 and two input unit columns 6X and 6Y provided in the height direction of the panel body 4.

The above-described respective input units 6a to 61 may have the same structure.

That is, each of the input units 6a to 61 may include a contact part 61 provided on the surface of the panel body 4 so that bioelectric currents of a user are input to the contact part 61, a bar 65 electrically connected to the controller 53, and a connection damper 67 electrically connecting the bar 65 and the contact part 61.

The bar 65 is formed of a conductor and located under the contact part 61. It is desirable that the bar 65 is fixed to the PCB 51.

The contact part 61 may be formed of any material which may transmit bioelectric currents of the user to the connection damper 67. That is, the contact part 61 may be formed of a conductor passing through the panel body 4, or formed of an insulator having a small thickness.

Since such an insulator having a small thickness is not a perfect insulator which completely cut off electrical conduction, even if the contact part 61 is formed of an insulator of less than a designated thickness, bioelectric currents of the user may be transmitted to the connection damper 67. The applicant has confirmed that the function of the input unit 6 may be implemented through the contact part 61 formed of plastic having a thickness of 2.7 to 3.0 mm.

Further, if the contact part 61 is formed of an insulator having a small thickness, the input unit 6 may further include a boundary part 63 in the form of a closed curve surrounding the outer circumferential surface of the contact part 61.

The boundary part 63 may be formed of a conductor fixed to the surface of the panel body 4 so as to surround the outer circumferential surface of the contact part 61. The reason for this is to concentrate bioelectric currents of the user on the boundary part 63 formed of a conductor and thus to prevent bioelectric currents from moving to the outside of the contact part 61.

The connection damper 67 may be fixed to the upper surface of the bar 65. Further, the connection damper 67 may include a conductor 671 connecting the contact part 61 and the bar 65.

If the connection damper 67 includes the conductor 671 alone, manufacturing costs of the control panel CP increase and, when impact is applied to the control panel CP, the connection damper 67 may break.

Therefore, the connection damper 67 in the present invention may further include an elastic body 673. In this case, the outer circumferential surface of the elastic body 673 may be surrounded with the conductor 671. Therefore, the conductor 671 executes transmission of bioelectric currents, and the elastic body 673 executes impact absorption.

As exemplarily shown in FIG. 3, the control panel CP in accordance with the embodiment of the present invention may include a plurality of input units 6a to 61. The input units 6a to 6f provided in the length direction of the panel body 4 may control the light emission units 57 under the light discharge unit columns 431 to 436 located at positions corresponding to these input units 6a to 6f.

That is, in the embodiment of the present invention, one input unit located in one of the light emission unit columns 571, 572, 573, 574, 575, and 576 turns a plurality of light emission units 57 forming the light emission unit column 571, 572, 573, 574, 575, or 576 ON/OFF (ON: emitting light, OFF: not emitting light), or controls change of the position of the light emission unit 57 in the ON state.

In this case, whenever a user's body contacts the input unit 6, the controller 53 may sequentially supply power to the plurality of light emission units 57 forming the light emission unit column 571, 572, 573, 574, 575, or 576 (only one light emission unit emitting light).

Further, whenever a user's body contacts the input unit 6, the controller 53 may control the light emission units 57 so that the position of the light emission unit 57 brighter than other light emission units 57 sequentially moves.

The input units 6g to 6i forming the input unit first column 6X and the input units 6j to 61 forming the input unit second column 6Y are provided in the same number as the number of the light emission units 57 and thus, the controller 53 may control only the light emission units 57 located under the input units 6g to 61 sensing bioelectric currents (turning the light emission units 57 ON/OFF or controlling brightness of the light emission units 57).

The panel body 4 may further include a power input unit 8 controlling supply of power to an element requiring power supply, such as the driving unit 3 or the control unit 5, and a pause input unit 9 temporarily stopping operation of the clothes treating apparatus 100 or releasing temporary stoppage of the clothes treating apparatus 100.

The power input unit 8 and the pause input unit 9 may be provided as a push button which is operated only when a user presses the button at a designated pressure or more, or have the same structure as the above-described structure of the input units 6.

In the latter case, the power input unit 8 and the pause input unit 9 may include contact parts 81 and 91 provided on the surface of the panel body 4 so that bioelectric currents of a user may be input to the contact parts 81 and 91, boundary parts 83 and 93 in the form of a closed curve surrounding the outer circumferential surfaces of the contact parts 81 and 91, bar 85 and 95 electrically connected to the controller 53 and fixed to the PCB 51, and connection dampers 87 and 97 electrically connecting the bars 85 and 95 and the contact part 81 and 91.

If bioelectric currents are simultaneously input to several input units 6, 8, and 9 of the control panel CP having the above-described structure, a control command against user intention may be input to the clothes treating apparatus 100.

That is, the above problem may be occur if a user's body except for fingers contacts the panel body 4 and thus bioelectric currents are supplied to several input units or if a user's hand contacts the panel body 4 without user intention of inputting a control command and thus bioelectric currents are simultaneously supplied to several input units.

In order to solve such a problem, the control unit 5 in the present invention may execute control, which will be described below.

First, the control unit 5 continuously judges whether or not bioelectric currents of a user are input through the input units 6, 8, and 9.

If bioelectric currents are input through the input units 6, 8, and 9, the control unit 5 judges through which input units bioelectric currents are input.

If bioelectric currents are input through one input unit, the control unit 5 controls the clothes treating apparatus 100 according to a control command input through the corresponding input unit.

That is, if bioelectric currents are input through one input unit, the control unit 5 supplies power to the clothes treating apparatus 100, temporarily stops operation of the clothes treating apparatus 100, re-operate the clothes treating apparatus 100, operation of which has been temporarily stopped, or controls the light emitting units 57 and the display unit 55 so that the user may confirm the selected control command.

If bioelectric currents are input through two or more input units, the control unit 5 judges whether or not an input interval of bioelectric currents exceeds a predetermined reference interval.

If the input interval of two or more bioelectric currents exceeds the reference interval (time), the control unit 5 sequentially executes respective control commands input through the input units. On the other hand, if the input interval of two or more bioelectric currents does not exceed the reference interval, the control unit 5 disregards control commands input through the input units.

That is, if the input interval of two or more bioelectric currents does not exceed the reference interval, the control unit 5 maintains the current state of the clothes treating apparatus 100. The control unit 5 continuously executes a control command which is being executed now if the clothes treating apparatus 100 is being operated, and controls the clothes treating apparatus 100 so that power is not supplied to the clothes treating apparatus 100 if the clothes treating apparatus 100 is not being operated.

Conventional control panels including light emission units (LEDs) control brightness of the light emission units by controlling the amount of current supplied to the light emission units. However, in the present invention, brightness of the light emission units 57 is adjusted by controlling a duty cycle of the light emission units 57.

The duty cycle is a value meaning a ratio of a time, during which current is supplied, to 1 cycle (a time during which current is supplied / the sum of the time during which current is supplied and a time during which current is not supplied), and 1 cycle means the sum of a time during which current is supplied to light emission units and a time during which current is not supplied to the light emission units.

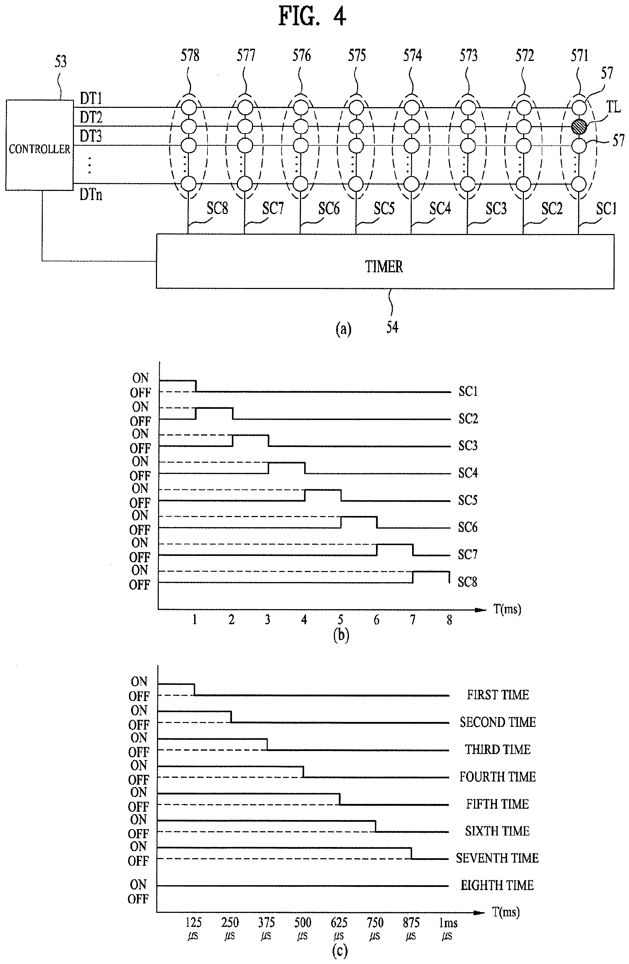

FIG. 4(a) exemplarily illustrates the control unit 5 which may adjust brightness of the light emission units 57 by controlling the duty cycle of the light emission units 57 (or the ON/OFF cycle of the light emission units).

The light emission units 57 fixed to the PCB 51 are connected to the controller 53 through data lines DT1 to DTn and scan lines SC1 to SC8.

The data lines DT1 to DTn and the scan lines SC1 to SC8 may be structurally discriminated.

The data lines DT1 to DTn and the scan lines SC1 to SC8 differ from each other in that the data lines DT1 to DTn are connected directly to the controller 53 but the scan lines SC1 to SC8 are connected to the controller 53 via a timer 54. Further, the data lines DT1 to DTn and the scan lines SC1 to SC8 differ from each other in that the data lines DT1 to DTn are provided on the PCB 51 so that light emission units 57 forming one row are controlled by the controller 53 but the scan lines SC1 to SC8 are provided on the PCB 51 so that light emission units 57 forming one column are controlled by the controller 53 and the timer 54.

From a functional viewpoint, the respective scan lines SC1 to SC8 supply current of a designated intensity to the respective light emission unit columns 571 to 578 at a regular cycle but the data lines DT1 to DTn cause a specific light emission unit 57 to emit light (to turn the specific light emission unit 57 on/off) by controlling a time during which the specific light emission unit 57 receives current from a specific scan line (i.e., controlling a duty cycle).

The timer 54 may serve not only to control a supply time of current (of a regular intensity) supplied by one scan line (i.e., control a current supply cycle) (with reference to FIG. 4(c)) but also not to supply current simultaneously to all scan lines SC1 to SC8 but to supply current to the respective scan lines SC1 to SC8 according to a regular cycle, if plural scan lines are provided, (with reference to FIG. 4(b), i.e., to supply current to the respective scan lines at a regular cycle).

If 8 scan lines are provided, the timer 54 may supply current to the respective scan lines at a 1/8 cycle.

That is, as exemplarily shown in FIG. 4(b), the timer 54 supplies current to the first scan line SC1 for 1ms and then does not supply current to the first scan line SC1 until 7ms has elapsed (for a time during which current is sequentially supplied to the second scan line SC2 to the eighth scan line SC8 for 1ms).

If the timer 54 may control a current supply time in the unit of 125 *µ*s at the minimum, the timer 54 may supply current to one scan line based on eight kinds of current supply times shown in FIG. 4(c), while current is supplied to one scan line. That is, when current is supplied at a 1/8 cycle, current may be supplied based on one of eight kinds of current supply times.

That is, on the assumption that the first scan line SC1 is a scan line to which current is supplied now, the timer 54 may supply current to the first scan line SC1 for the first time (125 *µ*s) at the minimum to the eighth time (1 ms) at the maximum.

A process of controlling brightness of the light emission units 57 through the control unit 5 having the above-described structure will be described, as follows.

The timer 54 sequentially supplies current to the respective scan lines SC1 to SC8 according to a set cycle. At this time, the controller 53 transmits a signal, connecting a specific light emission unit to a specific scan line, to the respective light emission units 57 through the data lines.

For example, the timer 54 supplies current of the same intensity to the respective light emission units 57 according to a preset cycle (1/8: supplying current for 1 ms and cutting off current for 7 ms).

At this time, the controller 53 transmits a signal, connecting a light emission unit (hereinafter, referred to as "a target light emission unit") TL located at the second row of the first light emission unit column 571 to a scan line for 1 ms and separating the target light emission unit TL from the scan line for 7 ms, to the target light emission unit TL through the data line DT2.

Further, the controller 53 transmits a signal, connecting the light emission units 57 except for the target light emission unit TL (hereinafter, referred to as "background light emission units") to scan lines for 0.5 ms and separating the background light emission units 57 from the scan lines for 15.5 ms, to the respective light emission units 57 through all data lines DT1, DT2, DT3, ..., DTn.

In this case, the duty cycle of the target light emission unit TL becomes 1/8 (cycle of 8 ms) and the duty cycle of the background light emission units 57 becomes 1/32 (cycle of 16 ms). That is, the duty cycle of the target light emission unit TL may be 4 times the duty cycle of the background light emission units 57. Therefore, if current of the same intensity is supplied to the light emission units 57 and the duty cycle is varied, the target light emission unit TL emits light more brightly than the background light emission units 57. That is, if the current supply cycle of the background light emission units 57 is lengthened (the frequency of the background light emission units 57 is decreased), a user may feel that the target light emission unit TL is brighter than the remaining background light emission units 57.

Further, if the frequency of the light emission units 57 is not less than a critical frequency (about 10Hz) at which flickering is recognizable by shortening a cycle at which power is supplied to the light emission units 57, the user may not recognize flickering of the light emission units 57. Therefore, the user may recognize that the target light emission unit TL continuously maintains a brighter state than the background light emission units 57.

The frequency in the duty cycle of the background light emission units 57 may be 31.25 Hz, and the frequency in the duty cycle of the target light emission unit TL may be 125 Hz. Therefore, the user may clearly recognize whether or not the target light emission unit TL and the background light emission units 57 emit light and a brightness difference between the target light emission unit TL and the background light emission units 57.

Therefore, in the present invention, brightness of the light emission units is controlled through control of the duty cycle of current supplied to the respective light emission units without change in intensity of current supplied to the respective light emission units.

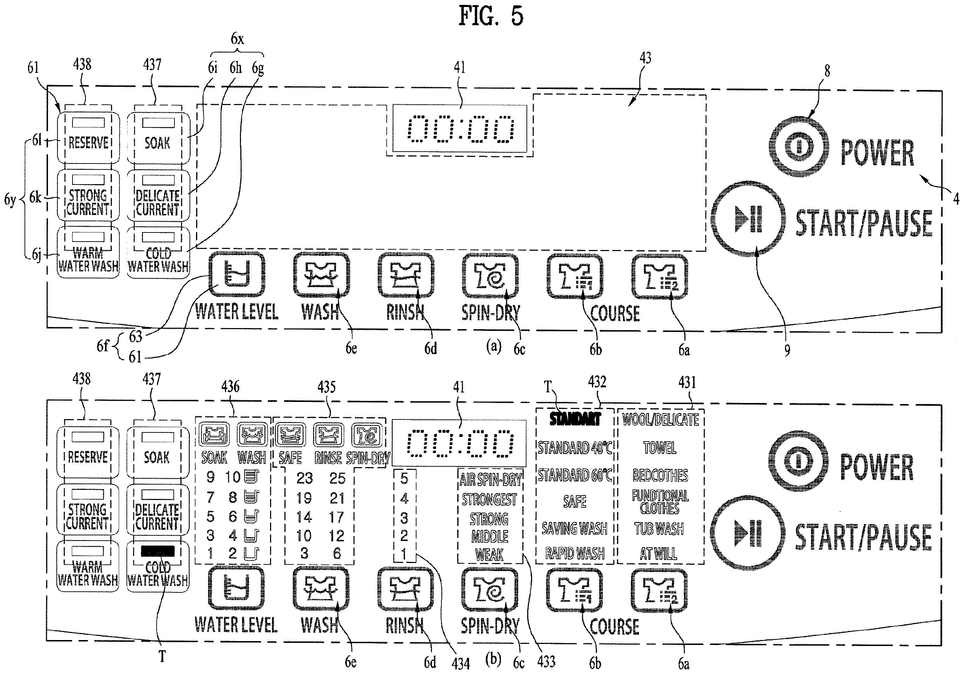

FIGs. 5(a) and 5(b) illustrate an operating process of the control panel CP when a user inputs a power supply command to the clothes treating apparatus 100 through the power input unit 8 in accordance with one embodiment of the present invention.

In this embodiment, when a user inputs a control command (power supply command) to the clothes treating apparatus 100 through the power input unit 8, the light emission units 57 are controlled so that a predetermined target light emission unit TL alone maintains a bright state, and the remaining light emission units 57 have lower brightness than the target light emission unit TL.

The target light emission unit TL means a light emission unit 57 located under a target light discharge unit T and the target light discharge unit T means a light discharge unit 43 displaying a course having high frequency of use and detailed settings having high frequency of use.

The target light discharge unit T may be set by a user or set by a designer of the clothes treating apparatus 100. FIG. 5 exemplarily illustrates the case that a light discharge unit displaying standard (normal) washing using cold water is set as the target light discharge unit T.

Since current is not supplied to the light emission units 57 unless a user's body (a finger, etc.) contacts the power input unit 8, the user may not recognize the light discharge units 43 in the form of characters, figures, or marks unless current is supplied to the light emission units 57.

Such effects may be maximized if the panel body 4 is coated or painted with a material of an achromatic color, such as black. Therefore, the entirety of the light emission units 43 may be recognized as a black panel display.

If a user's body contacts the power input unit 8, the timer 54 supplies current to one of the scan lines SC1 to SC8, selected according to the set cycle (supplying current for 1 ms/cutting off supply of current for 7 ms), for a set time (one of the first time to the eighth time of FIG. 4(c)).

Simultaneously, the respective data lines DT1 to DT8 supply current to the respective light emission units 57 under control of the controller 53 so that the duty cycle of the target light emission unit located under the target light discharge unit T is greater than that of the remaining light emission units.

For example, if a user's body contacts the power input unit 8, the timer 54 selects one scan line in a cycle of 8 ms (supplying current for 1 ms/cutting off supply of current for 7 ms), and supplies current of a regular intensity to the selected scan line for a designated time (for example, for 1 ms (the eighth time).

At this time, the controller 53 transmits a control signal (duty cycle: 1/8 and frequency: 125Hz), connecting a target light emission unit to a scan line for 1 ms and separating the target light emission unit from the scan line for 7 ms, to the target light emission unit, and transmits a control signal (duty cycle: 1/32 and frequency: about 31.25Hz), connecting the background light emission units to scan lines for 0.5 ms and separating the background light emission units from the scan lines for 15.5 ms, to the background light emission units.

In the above-described case, the frequencies of all light emission units including the target light emission unit are not less than the critical frequency (about 10Hz) at which flickering is recognizable and thus, a user may not recognize flickering of the light emission units, and the duty cycle of the target light emission unit is greater than the duty cycle of the background light emission units and thus, the user may recognize that a course displayed by the target light discharge unit T located above the target light emission unit is selected.

Therefore, in the present invention, the light emission units have frequencies at which flickering is not recognizable, being not less than the critical frequency and thus, a user may not recognize flickering while adjusting brightness of the light emission units through control of the duty cycles of the light emission units.

Of course, in the state shown in FIG. 5(b), as the user presses a course input unit 6b, the target light emission unit is sequentially changed. That is, the target light emission unit of the second light emission unit column 432 corresponding to the course input unit 6b may be varied. Therefore, the user may clearly recognize a selected course.

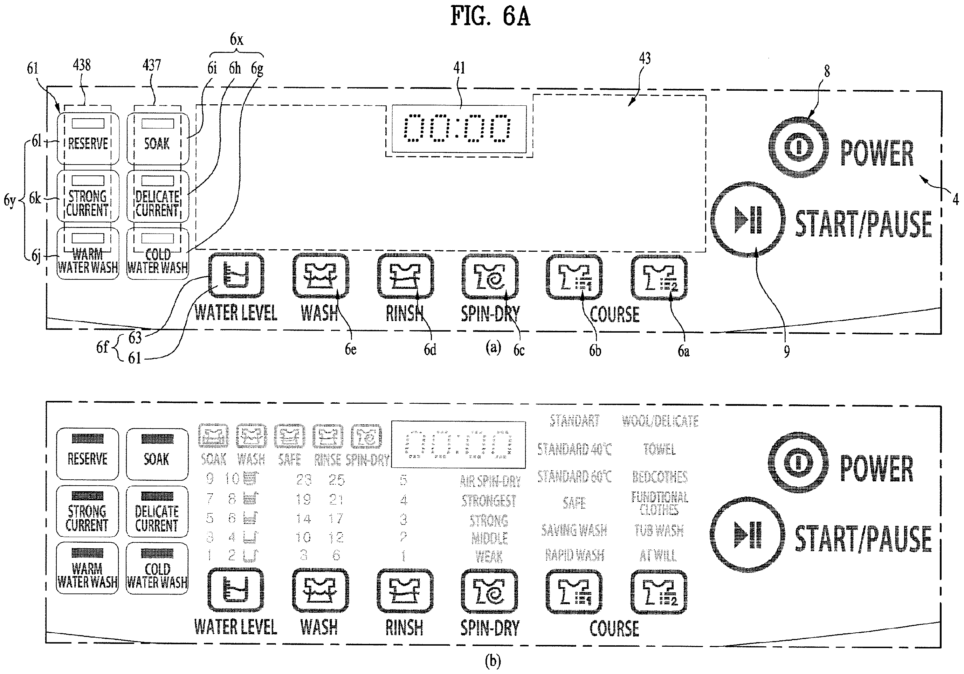

FIGs. 6A(a) to 6B(b) illustrate an operating process of the control panel CP when a user input a power supply command to the clothes treating apparatus 100 through the power input unit 8 in accordance with another embodiment of the present invention.

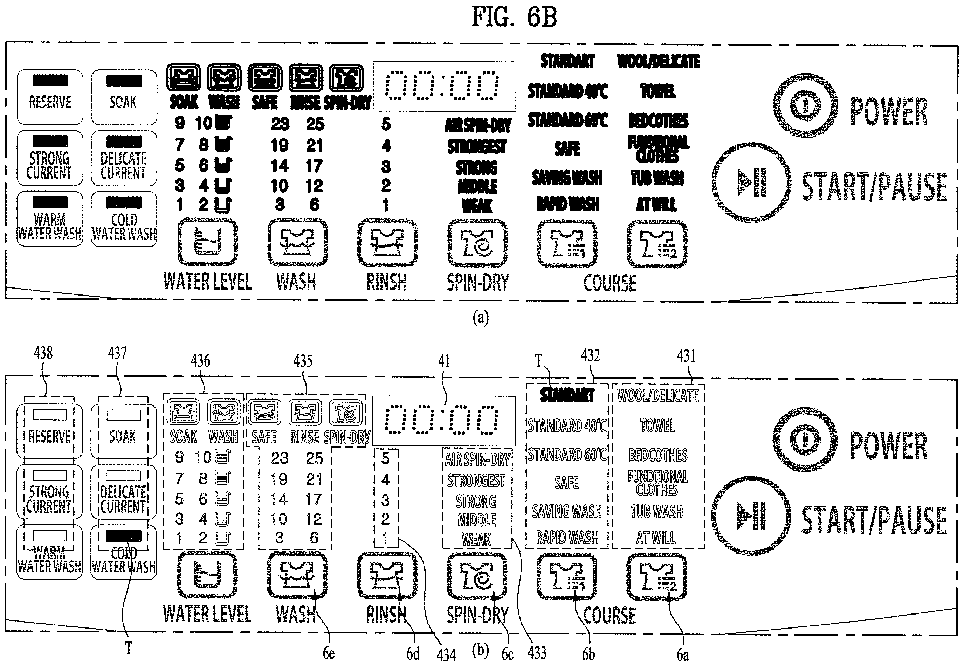

The embodiment of FIGs. 6A(a) to 6B(b) is characterized in that the light discharge units 43 are gradually brightened in stages and then, the target light emission unit T maintains the bright state and the background light emission units are gradually darkened and maintain a darker state than the target light emission unit T, differently from the embodiment of FIGs. 5(a) and 5(b). That is, when power is supplied, the control panel CP may reach a state shown in FIG. 6B(b) in stages. The state shown in FIG. 6B(b) may be the same as the state of FIG. 5(b)

In this embodiment, unless a user inputs the power supply command, current is not supplied to the light emission units 57 and thus, the user may not recognize the light discharge units 43 in the form of characters, figures, or marks (FIGs. 6A(a)).

The timer 54 may control a time (i.e., one of the first time to the eighth time) during which current is supplied to a selected scan line while changing the scan line to which current will be supplied per ms (with reference to FIGs. 4(b) and 4(c)).

Therefore, when a user inputs a power supply command through the power input unit 8, the timer 54 selects one of the first scan line SC1 to the eighth scan line SC8 in the unit of 1 ms and supplies current of a regular intensity to the selected scan line for the first time (125 *µ*s). When the controller 53 transmits the scan line supplying current to the respective light emission units 57 and a signal (the first duty cycle, 125 *µ*s/(7 ms+825 *µ*s)), connecting the light emission units 57 to the scan line for 125 *µ*s through the data lines, the eight light emission unit columns 571 to 578 may maintain brightness of the lowest level (brightness of a first level) for a designated time (FIG. 6A(b)).

On the other hand, when the timer 54 selects one of the first scan line SC1 to the eighth scan line SC8 per ms and supplies current of a regular intensity to the selected scan line for the eighth time (1 ms) and the controller 53 transmits a signal (the eighth duty cycle, 1/8) connecting all the light emission units 57 to the scan line for 1 ms through the data lines, the eight light emission unit columns 571 to 578 may maintain brightness of the highest level (brightness of a eighth level) for a designated time (FIG. 6B(a)).

Therefore, if a process of controlling the light emission units to implement brightness between the first level and the eighth level is provided between the state shown in FIG. 6A(b) and the state shown in FIG. 6B(a), the present invention may implement an image in which the light discharge units 43 are gradually brightened according to at least two brightness levels.

As exemplarily shown in FIG. 6B(a), when the eight light emission unit columns 571 to 578 reach brightness of the eighth level, the light emission units are controlled so that the target light emission unit maintains brightness of the eighth level but the background light emission units are gradually darkened to brightness of the first level.

That is, when the eight light emission unit columns 571 to 578 reach brightness of the eighth level, the timer 54 selects one of the first scan line SC1 to the eighth scan line SC8 per ms and supplies current to the selected scan line for the eighth time (1 ms). The controller 53 may transmit a control signal (the duty cycle, 1/8), connecting the target light emission unit to the scan line for 1 ms and separating the target light emission unit from the scan line for 7 ms, to the target light emission unit and transmit a signal, connecting the background light emission units to the scan line only for 125 *µ*s, to the background light emission units (FIG. 6B(b)).

Therefore, the target light discharge unit T located above the target light emission unit maintains a brighter state than the remaining light discharge units and thus, a user may recognize that a course displayed by the target light discharge unit T is selected.

Of course, in the state shown in FIG. 6B(b), as the user presses the course input unit 6b, the target light emission unit is sequentially changed. That is, the target light emission unit of the second light emission unit column 432 corresponding to the course input unit 6b may be varied. Therefore, the user may clearly recognize a selected course.

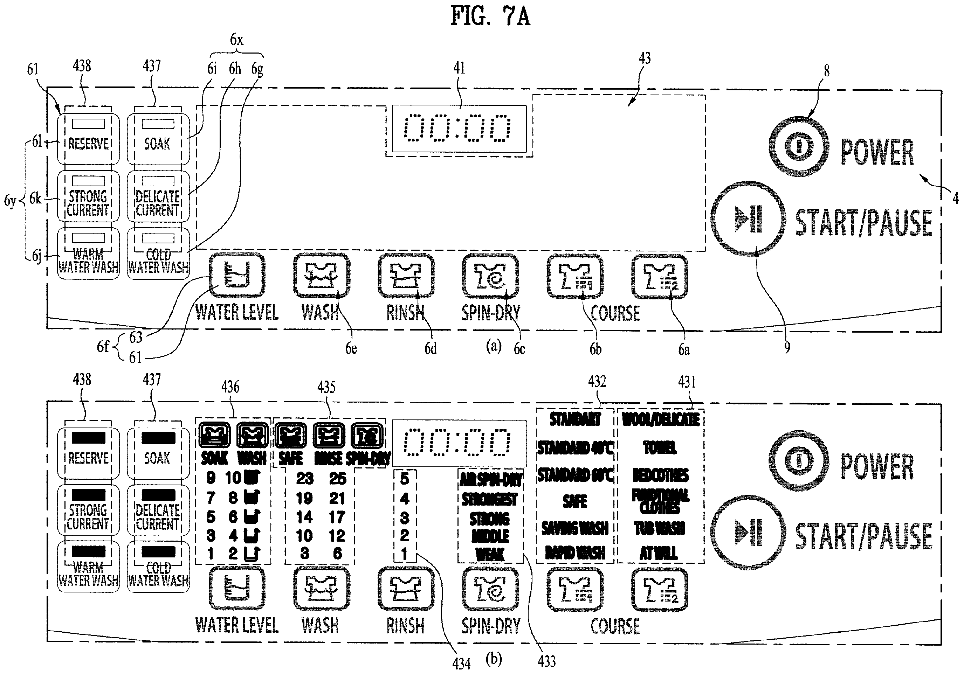

The embodiment of FIGs. 7A(a) to 7B is characterized in that, when a user inputs a power supply command through the power input unit 8, all the light emission units 57 become the brightest state (the eighth level) and then, the remaining light emission units 57 except for a target light emission unit (a light emission unit located under a target light discharge unit T) are gradually darkened and become the darkest state (the first level), differently from the embodiment of FIGs. 6A(a) to 6B(b).

That is, in a state shown in FIG. 7A(a), when the user inputs the power supply command through the power input unit 8, the timer 54 selects one of the first scan line SC1 to the eighth scan line SC8 per ms and then, supplies current of a regular intensity to the selected scan line for the eighth time (1 ms).

At this time, the controller 53 transmits a control signal (the duty cycle of 1/8), connecting the light emission units to the scan line for 1 ms and separating the light emission units from the scan line for 7 ms, to all the target light emission units. Therefore, all the light discharge units 43 may maintain the brightest state, as exemplarily shown in FIG. 7A(b).

Thereafter, the timer 54 selects one of the first scan line SC1 to the eighth scan line SC8 per ms and then, supplies current of a regular intensity to the selected scan line for the eighth time (1 ms). The controller 53 may maintain the duty cycle of the target light emission unit (the duty cycle of 1/8) but lower the duty cycle of the background light emission units (transmitting a signal, connecting the background light emission units to the scan line only for 125 *µ*s, to the background light emission units).

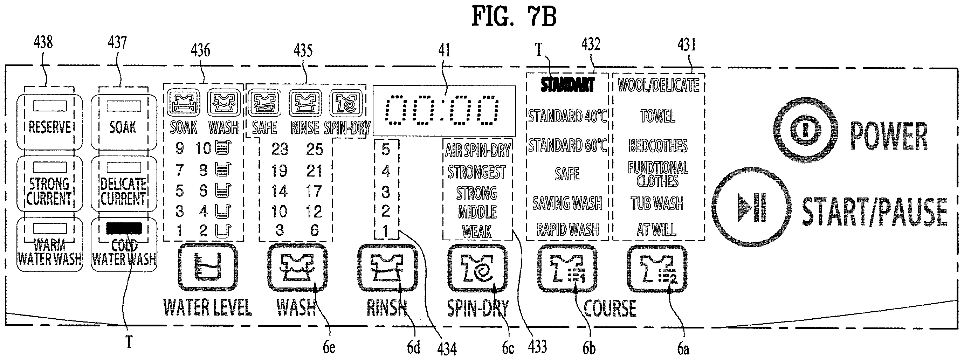

Therefore, the target light discharge unit T maintains a brighter state than the background light discharge units, as exemplarily shown in FIG. 7B, and thus, a user may recognize that a course displayed by the target light discharge unit T is selected.

If a process of controlling the light emission units to implement brightness between the first level and the eighth level is provided between the state shown in FIG. 7A(b) and the state shown in FIG. 7B, the present invention may implement an image in which the light discharge units 43 are gradually darkened according to at least two brightness levels.

As exemplarily described with reference to FIGs. 5(a) to 7B, when power is applied, the control panel CP may become the same state, as exemplarily shown in FIGs. 5(b), 6B(a), and 7B. That is, the control panel CP becomes a state in which a user may input a control command to the control panel CP. These embodiments mean that brightness of the light emission units may be differently adjusted in various manners until the control panel CP becomes the state in which a user may input a control command to the control panel CP after power is applied. Therefore, the control panel CP may implement a minimal design before power is applied to the control panel CP, and have increased visibility when power is applied to the control panel CP.

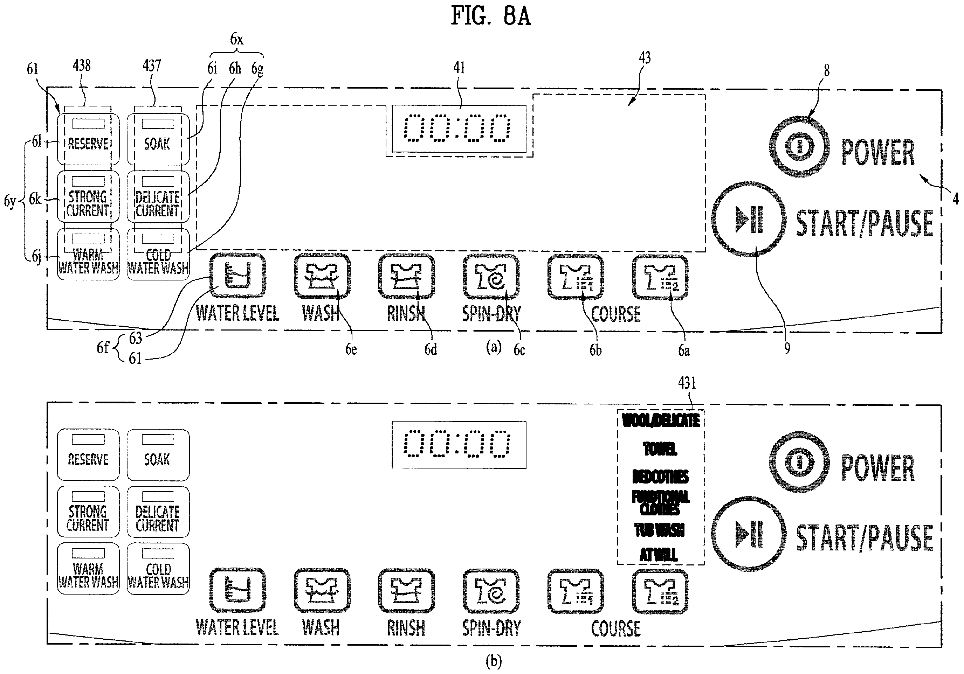

The embodiment of FIGs. 8A(a) to 8C is characterized in that, when a user inputs a power supply command through the power input unit 8, the first light emission unit column 571 to the eighth light emission unit column 578 are controlled so as to be sequentially brightened (to sequentially emit light).

Particularly, in this embodiment, the light emission units may be controlled so that, when one of the light emission unit columns 571 to 578 emits light, the light emission unit column previously emitting light maintains a dark state, as compared to the light emission unit column currently emitting light.

That is, in this embodiment, the light emission units may be controlled so that, when the power supply command is input, the first light emission unit column 571 maintains brightness of the eighth level for a designated time and, when a predetermined time has elapsed, the second light emission unit column 572 has brightness of the eighth level and the first light emission unit column 571 has brightness of the seventh level or less.

In a state shown in FIG. 8A(a), when a user inputs the power supply command through the power input unit 8, the timer 54 selects one of the first scan line SC1 to the eighth scan line SC8 in the unit of 1 ms and then, supplies current of a regular intensity to the selected scan line for the eighth time (1 ms).

When current is supplied to the first scan line SC1 for the eighth time, the controller 53 transmits a control signal (the duty cycle of 1/8), connecting the light emission units to the first scan line SC1 for 1 ms, only to the light emission units forming the first light emission unit column 571. Therefore, the first light discharge unit column 431 located above the first light emission unit column 571 maintains brightness of the eighth level (the brightest state) (FIG. 8A(b)).

A time (reference time) during which the first light discharge unit column 431 maintains brightness of the eighth level may vary according to frequency of repetition of a current supply cycle. While the timer 54 supplies current only to the first scan line SC1, the brightness maintenance time is proportional to the frequency of repetition of control of supplying current only to the first light discharge unit column 431 by the controller 53.

The timer 54 supplies current of a regular intensity to the first scan line SC1 for one of the first time to the eighth time (with reference to FIG. 4(c)) in a cycle of 8 ms. Only if the first scan line SC1 is selected, the controller 53 may transmit a control signal, connecting the light emission units to the first scan line, to the light emission units forming the first light emission unit column 571. Such transmission may be performed for n cycles (n being 2 or more). Therefore, the first light emission unit column 571 may maintain brightness of a regular level for the reference time (time corresponding to a multiple of the cycle).

Once the first light emission unit column 571 emits light of brightness of a regular level for the reference time, the controller 53 transmits a control signal (the duty cycle of 1/8), connecting the light emission units to the second scan line SC2 for 1 ms, only to the light emission units forming the second light emission unit column 572, while the timer 54 supplies current to the second scan line SC2 for the eighth time (1 ms).

Simultaneously, the controller 53 transmits a control signal, connecting the light emission units to the first scan line SC1 for 875 *µ*s, to the light emission units 57 of the first light emission unit column 571, while the timer 54 supplies current to the first scan line SC1 for the seventh time (875 *µ*s).

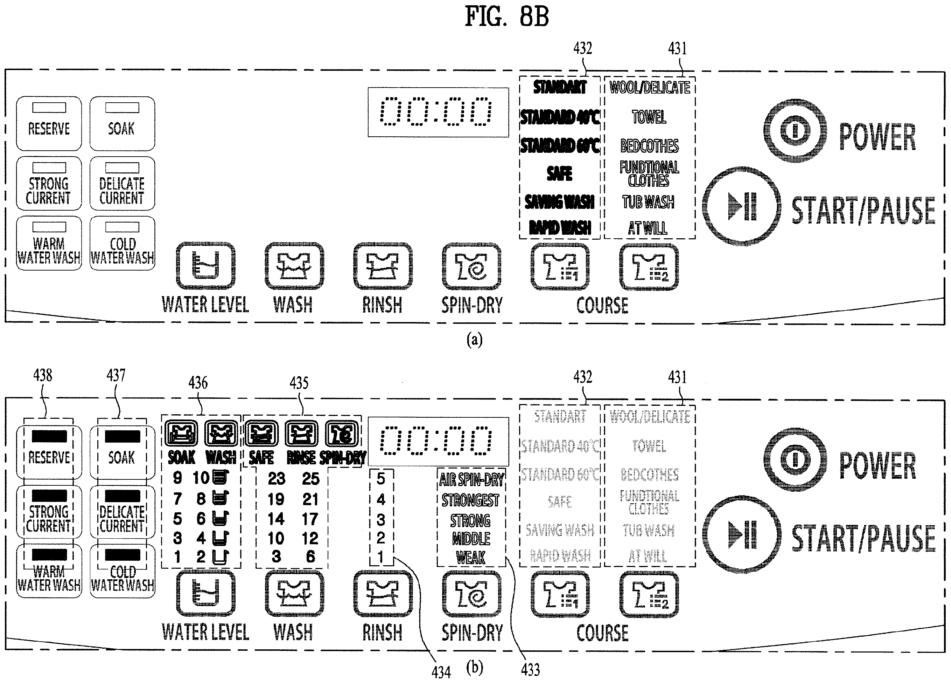

When such control is maintained for a time (reference time) corresponding to a multiple of the cycle of the scan lines, the second light discharge unit column 432 maintains the brightest state (the eighth level) for the maintenance time and the first light discharge unit column 431 maintains the darker state (the first level) than the second light discharge unit column 432 for the maintenance time (FIG. 8B(a)).

When the controller 53 controls the light emission units 57 so that the eighth light emission unit column 578 to the first light emission unit column 571 are connected to the scan lines for 1 ms, 875 *µ*s, 750 *µ*s, 625 *µ*s, 500 *µ*s, 375 *µ*s, 250 *µ*s, and 125 *µ*s, while the timer 54 sequentially supplies current to the eighth scan line SC8 to the first scan line SC1 for 1 ms (the eighth time), 875 *µ*s, 750 *µ*s, 625 *µ*s, 500 *µ*s, 375 *µ*s 250 *µ*s, and 125 *µ*s (the first time), the light discharge units 43 may maintain a state in which the light discharge units 43 are gradually darkened in a direction from the eighth light emission unit column 438 to the first light emission unit column 431 (FIG. 8B(b)).

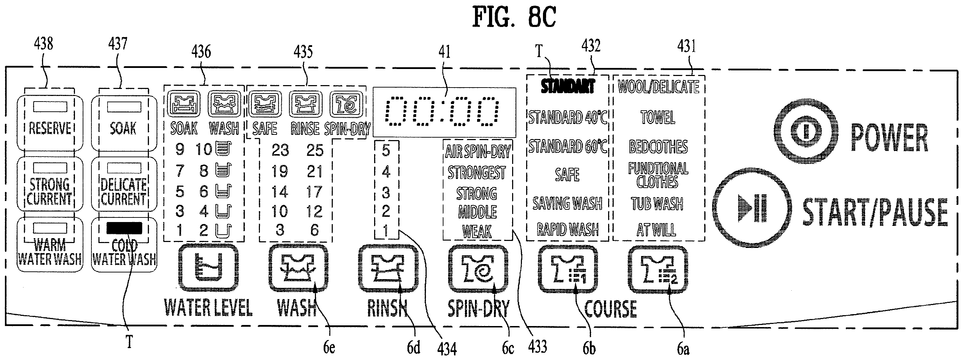

Thereafter, the timer 54 may select one of the first scan line SC1 to the eighth scan line SC8 per ms and then, supply current of a regular intensity to the selected scan line for the eighth time (1 ms), and the controller 53 may transmit a control signal (the duty cycle of 1/8), connecting light emission units to the scan line for 1 ms, to the target light emission unit and transmit a control signal, connecting light emission units to the scan line only for a shorter time than 1 ms (for example, 125 *µ*s), to the background light emission units (FIG. 8C).

Although the above embodiment illustrates the light emission unit column having brightness of the eighth level as moving from the first light emission unit column 571 to the eight light emission unit column 578, the light emission unit column having brightness of the eighth level may move from the eighth light emission unit eighth column to the first light emission unit first column 571.

Further, in the present invention, a light emission unit row having brightness of the eighth level may move from the lower end of the panel body 4 to the upper end of the panel body 4 or move from the upper end of the panel body 4 to the lower end of the panel body 4.

Further, in the present invention, a light emission unit column of a diagonal line type having brightness of the eighth level may move from an upper corner of the panel body 4 to a lower corner of the panel body 4.

Moreover, although the above-described embodiment illustrates the eight light emission unit columns as having brightness of different levels, the light emission unit column maintaining brightness of the eighth level may move from one side of the panel body 4 to the other side of the panel body 4 but the remaining light emission unit columns may be fixed to brightness of a low level (the first level or the second level).

That is, once the second light emission unit column 572 emits light of brightness of the eighth level for the reference time, the controller 53 may control the light emission units 57 so that the third light emission unit column 573 emits light of brightness of the eighth level for the reference time and the second light emission unit column 572 and the first light emission unit column 571 maintain brightness of the first level for the reference time.

In more detail, the scan lines may be controlled so that the timer 54 supplies current to the third scan line SC3 for the eighth time (1 ms) and supplies current to the second scan line SC2 and the first scan line SC1 for the first time (125 *µ*s). Further, the controller 53 may transmit a control signal (the duty cycle of 1/8), connecting the light emission units to the third scan line SC3 for 1 ms, to the light emission units forming the third light emission unit column 573 and transmit a signal, connecting the light emission units 57 to the second scan line SC2 and the first scan line SC1 for 125 *µ*s, to the second light emission unit column 572 and the first light emission unit column 571. Thereby, the above-described control may be carried out.

Further, control of the light discharge units 43 according to the eight brightness levels may be carried out because the timer 54 in the above-described embodiment selects one scan line per ms and the current supply minimum time is set to 125 *µ*s. Therefore, the number of brightness levels of the light discharge units 43 may be modified according to specifications of the timer 54.

As exemplarily described with reference to FIGs. 5(a) to 8C, when power is applied, the control panel CP becomes the same state, as exemplarily shown in FIGs. 5(b), 6B(a), 7B, and 8C. That is, the control panel CP becomes a state in which a user may input a control command to the control panel CP. These embodiments mean that brightness of the light emission units may be differently adjusted in various manners until the control panel CP becomes the state in which a user may input a control command to the control panel CP after power is applied. Therefore, the control panel CP may implement a minimal design before power is applied to the control panel CP, and have excellent appearance and increased visibility when power is applied to the control panel CP.

Further, although the above-described embodiments illustrate a plurality of light emission units, the disclosure may be applied to control of one light emission unit.

Further, although the above-described control panel CP is applied to the top loading type clothes treating apparatus in which the clothes receipt unit 2 is provided in a direction vertical to the bottom surface of the cabinet 1, the control panel CP of the present invention may be applied to a front loading type clothes treating apparatus in which a clothes receipt unit 2 is provided in parallel with the bottom surface of a cabinet 1.

As apparent from the above description, in accordance with one embodiment of the present invention, a control panel through which a control command may be input using bioelectric currents of a user, and a clothes treating apparatus having the same may be provided.

In accordance with one embodiment of the present invention, a control panel which prevents a clothes treating apparatus from being operated against user intention even if bioelectric currents is input through two or more input units and a clothes treating apparatus having the same may be provided.

In accordance with one embodiment of the present invention, a control panel which may control brightness of light emission units through a time during which current is supplied and a clothes treating apparatus having the same may be provided.

In accordance with one embodiment of the present invention, a control panel in which a plurality of light emission units emits light in various patterns when a power supply signal is input to a clothes treating apparatus and a clothes treating apparatus having the same may be provided.

In accordance with one embodiment of the present invention, a control panel which a user may clearly recognize selection of a course displayed by a target light emission unit through a difference of brightness levels between the target light emission unit and background light emission units, a clothes treating apparatus having the control panel, and a control method thereof may be provided.

In accordance with one embodiment of the present invention, a control panel in which a user may clearly recognize whether or not a control command displayed by light discharge units is preset and whether or not the control command is selected by varying brightness levels of light emission units emitting light toward the light discharge units when power is supplied, a clothes treating apparatus having the control panel, and a control method thereof may be provided.

In accordance with one embodiment of the present invention, a control panel which may implement various initial light emitting patterns of light emission units after power is supplied and thus improve product satisfaction, a clothes treating apparatus having the control panel, and a control method thereof may be provided.

## Claims

1. A control method of a control panel of a clothes treating apparatus (100), which has a panel body (4) forming the external appearance of the control panel, a plurality of light discharge units (43) provided on the panel body so that light emitted from a plurality of light emission units (57) passes through the panel body, wherein the plurality of light emission units (57) are located under the plurality of light discharge units (43) and are emitting light toward the plurality of light discharge units (43), the plurality of light emission units (57) including a target light emission unit and background light emission units, and wherein the target light emission unit is set through selection of input units (6) by a user,
the control method comprising:
receiving a power supply command through a power input unit (8); and
controlling the target light emission unit so as to emit light more brightly than the background light emission units by differentiating a duty cycle of current supplied to each of the plurality of light emission units (57) between a duty cycle of the target light emission unit and a duty cycle of the background light emission units, when power is input, wherein the duty cycle of the target light emission unit and the duty cycle of the background light emission units are separately generated and controlled by a controller,
wherein the plurality of light emission units (57) are located in a matrix comprising a plurality of light emission unit columns and a plurality of light emission unit rows,
wherein a plurality of scan lines are each configured to connect light emissions of a respective light emission unit column, each light emission column receiving substantially equal current in a regular cycle through a respective scan line,
wherein a plurality of data lines (DT1, DT2, ... DTn) are each configured to connect light emission units of a respective light emission unit row and configured to control a time during which a particular light emission unit receives current through a particular scan line (SC),
wherein respective light emission unit columns receive current of the same intensity at a regular cycle through the scan lines,
wherein a current supply time of the scan lines is controlled through a timer (54) and current is not supplied simultaneously to more than one of the scan lines and is supplied to the respective scan lines according to a designated cycle through the timer (54),
wherein the target light emission unit is controlled so as to emit light at the brightest level and the background light emission units are controlled so as to emit light at the darkest level, and
wherein, when power is input, all the light emission units (57) become the brightest state and then, the remaining light emission units except for the target light emission unit are gradually darkened and become the darkest state..

2. The control method according to claim 1, wherein current of the same intensity is supplied to the plurality of light emission units (57) and the duty cycle of the target light emission unit is controlled to be greater than the duty cycle of the background light emission units.

3. The control method according to claim 2, wherein the duty cycle of the target light emission unit is controlled to be 4 times the duty cycle of the background light emission units.

4. The control method according to any one of claims 1 to 3, wherein the timer (54) supplies current to the scan lines (SC) according to a plurality of current supply times.

5. The control method according to claim 4, wherein the plurality of current supply times includes 1 ms, 875 *µ*s, 750 *µ*s, 625 *µ*s, 500 *µ*s, 375 *µ*s, 250 *µ*s, and 125 *µ*s.

6. The control method according to any one of claims 1 to 5, wherein:
the control panel includes the controller (53) operating the clothes treating apparatus (100) according to a control command input through input units (6); and
the controller (53) transmits a signal, connecting a specific light emission unit to a specific scan line (SC), to the respective light emission units through the data lines (DT1, DT2, .. DTn).

7. The control method according to claim 6, wherein the controller (53):
transmits a signal, connecting the target light emission unit to the scan line (SC) and separating the target light emission unit from the scan line in the duty cycle of the target light emission unit, to the target light emission unit through the data lines (DT1, DT2, ... DTn);
transmits a signal, connecting the background light emission units to the scan lines (SC) and separating the background light emission units from the scan lines (SC) in the duty cycle of the background light emission units, to the background light emission units except for the target light emission unit through the data lines (DT1, DT2, ... DTn).

8. The control method according to any one of claims 1 to 7, wherein the target light emission unit is preset or set through selection by a user through input units (6).

9. The control method according to claim 8, wherein the plurality of light discharge units (43) displays control commands selectable by a user through input units (6) on the panel body (4), and a light emission unit (57) corresponding to a control command selected through the input units (6) is controlled at the duty cycle of the target light emission unit.

## Patentansprüche

1. Steuerverfahren eines Bedienfelds einer Kleiderbehandlungsvorrichtung (100), das einen Bedienfeldkörper (4), der die äußere Erscheinung des Bedienfelds bildet, und mehrere Lichtabgabeeinheiten (43) aufweist, die am Bedienfeldkörper vorgesehen sind, so dass von mehreren Lichtemissionseinheiten (57) emittiertes Licht den Bedienfeldkörper durchdringt, wobei die mehreren Lichtemissionseinheiten (57) unter den mehreren Lichtabgabeeinheiten (43) angeordnet sind und Licht zu den mehreren Lichtabgabeeinheiten (43) emittieren, wobei die mehreren Lichtemissionseinheiten (57) eine Ziel-Lichtemissionseinheit und Hintergrund-Lichtemissionseinheiten aufweisen, und wobei die Ziel-Lichtemissionseinheit durch Auswahl von Eingabeeinheiten (6) durch einen Benutzer eingestellt wird, wobei das Steuerverfahren aufweist:
Empfangen eines Stromversorgungsbefehls durch eine Stromeingabeeinheit (8); und
Ansteuern der Ziel-Lichtemissionseinheit, Licht heller als die Hintergrund-Lichtemissionseinheiten zu emittieren, indem eine Einschaltdauer des Stroms, der jeder der mehreren Lichtemissionseinheiten (57) zugeführt wird, zwischen einer Einschaltdauer der Ziel-Lichtemissionseinheit und einer Einschaltdauer der Hintergrund-Lichtemissionseinheiten unterschieden wird, wenn Strom zugeführt wird, wobei die Einschaltdauer der Ziel-Lichtemissionseinheit und die Einschaltdauer der Hintergrund-Lichtemissionseinheiten durch eine Steuereinheit getrennt erzeugt und gesteuert werden, wobei die mehreren Lichtemissionseinheiten (57) in einer Matrix angeordnet sind, die mehrere Lichtemissionseinheitsspalten und mehrere Lichtemissionseinheitsreihen aufweist,
wobei mehrere Abtastleitungen jeweils konfiguriert sind, Lichtemissionseinheiten einer jeweiligen Lichtemissionseinheitsspalte zu verbinden, wobei jede Lichtemissionseinheitsspalte in einem regelmäßigen Zyklus einen im Wesentlichen gleichen Strom durch eine jeweilige Abtastleitung empfängt,
wobei mehrere Datenleitungen (DT1, DT2, ... DTn) jeweils konfiguriert sind, Lichtemissionseinheiten einer jeweiligen Lichtemissionseinheitsreihe zu verbinden, und konfiguriert sind, eine Zeit zu steuern, während der eine bestimmte Lichtemissionseinheit Strom durch eine bestimmte Abtastleitung (SC) empfängt,
wobei jeweilige Lichtemissionseinheitsspalten in einem regelmäßigen Zyklus durch die Abtastleitungen Strom derselben Stärke empfangen,
wobei eine Stromzufuhrzeit der Abtastleitungen durch einen Zeitgeber (54) gesteuert wird und Strom nicht mehr als einer der Abtastleitungen gleichzeitig zugeführt wird und den jeweiligen Abtastleitungen durch den Zeitgeber (54) gemäß einem festgelegten Zyklus zugeführt wird,
wobei die Ziel-Lichtemissionseinheit so gesteuert wird, Licht auf der hellsten Stufe zu emittieren, und die Hintergrund-Lichtemissionseinheiten gesteuert werden, Licht auf der dunkelsten Stufe zu emittieren, und
wobei, wenn Strom zugeführt wird, alle Lichtemissionseinheiten (57) den hellsten Zustand annehmen und dann die restlichen Lichtemissionseinheiten mit Ausnahme der Ziel-Lichtemissionseinheit allmählich abgedunkelt werden und den dunkelsten Zustand annehmen.

2. Steuerverfahren nach Anspruch 1, wobei den mehreren Lichtemissionseinheiten (57) Strom derselben Stärke zugeführt wird und die Einschaltdauer der Ziel-Lichtemissionseinheit so gesteuert wird, dass sie größer als die Einschaltdauer der Hintergrund-Lichtemissionseinheiten ist.

3. Steuerverfahren nach Anspruch 2, wobei die Einschaltdauer der Ziel-Lichtemissionseinheit so gesteuert wird, dass sie das 4-fache der Einschaltdauer der Hintergrund-Lichtemissionseinheiten beträgt.

4. Steuerverfahren nach einem der Ansprüche 1 bis 3, wobei der Zeitgeber (54) den Abtastleitungen (SC) Strom gemäß mehreren Stromzufuhrzeiten zuführt.

5. Steuerverfahren nach Anspruch 4, wobei die mehreren Stromzufuhrzeiten 1 ms, 875 µs, 750 µs, 625 µs, 500 µs, 375 µs, 250 µs und 125 µs umfassen.

6. Steuerverfahren nach einem der Ansprüche 1 bis 5, wobei:
das Bedienfeld die Steuereinheit (53) aufweist, welche die Kleiderbehandlungsvorrichtung (100) gemäß einer Steuerbefehlseingabe durch die Eingabeeinheiten (6) betreibt; und
die Steuereinheit (53) ein Signal, das eine spezifische Lichtemissionseinheit mit einer spezifischen Abtastleitung (SC) verbindet, durch die Datenleitungen (DT1, DT2, ... DTn) an die jeweiligen Lichtemissionseinheiten sendet.

7. Steuerverfahren nach Anspruch 6, wobei die Steuereinheit (53):
ein Signal, das die Ziel-Lichtemissionseinheit mit der Abtastleitung (SC) verbindet und die Ziel-Lichtemissionseinheit von der Abtastleitung in der Einschaltdauer der Ziel-Lichtemissionseinheit trennt, durch die Datenleitungen (DT1, DT2, ... DTn) an die Ziel-Lichtemissionseinheit sendet;
ein Signal, das die Hintergrund-Lichtemissionseinheiten mit den Abtastleitungen (SC) verbindet und die Hintergrund-Lichtemissionseinheiten von den Abtastleitungen (SC) in der Einschaltdauer der Hintergrund-Lichtemissionseinheiten trennt, durch die Datenleitungen (DT1, DT2, ... DTn) an die Hintergrund-Lichtemissionseinheiten mit der Ausnahme der Ziel-Lichtemissionseinheit sendet.

8. Steuerverfahren nach einem der Ansprüche 1 bis 7, wobei die Ziel-Lichtemissionseinheit durch eine Auswahl durch einen Benutzer durch die Eingabeeinheiten (6) voreingestellt oder eingestellt wird.

9. Steuerverfahren nach Anspruch 8, wobei die mehreren Lichtabgabeeinheiten (43) Steuerbefehle anzeigen, die durch einen Benutzer durch die Eingabeeinheiten (6) auf dem Bedienfeldkörper (4) auswählbar sind, und eine Lichtemissionseinheit (57), die einem durch die Eingabeeinheiten (6) ausgewählten Steuerbefehl entspricht, mit der Einschaltdauer der Ziel-Lichtemissionseinheit gesteuert wird.

## Revendications

1. Procédé de commande d'un panneau de commande d'une machine à traiter des vêtements (100) comportant un corps de panneau (4) donnant son apparence extérieure au panneau de commande, une pluralité d'unités de dispersion lumineuse (43) prévues sur le corps de panneau de sorte que la lumière émise par une pluralité d'unités électroluminescentes (57) traverse le corps de panneau, où la pluralité d'unités électroluminescentes (57) est située sous la pluralité d'unités de dispersion lumineuse (43) et émet de la lumière vers la pluralité d'unités de dispersion lumineuse (43), la pluralité d'unités électroluminescentes (57) comprenant une unité électroluminescente cible et des unités électroluminescentes de fond, et où l'unité électroluminescente cible est réglée par sélection d'unités d'entrée (6) par un utilisateur, ledit procédé de commande comprenant :
la réception d'une instruction d'alimentation en énergie par une unité d'entrée d'alimentation (8) ; et
la commande de l'unité électroluminescente cible de manière à émettre une lumière plus vive que les unités électroluminescentes de fond par différenciation d'un cycle de travail du courant alimentant chacune des unités de la pluralité d'unités électroluminescentes (57), entre un cycle de travail de l'unité électroluminescente cible et un cycle de travail des unités électroluminescentes de fond, quand l'énergie est appliquée, le cycle de travail de l'unité électroluminescente cible et le cycle de travail des unités électroluminescentes de fond étant générés séparément et commandés par un contrôleur,
où la pluralité d'unités électroluminescentes (57) est disposée suivant une matrice comprenant une pluralité de colonnes d'unités électroluminescentes et une pluralité de rangées d'unités électroluminescentes,
où une pluralité de lignes de balayage est prévue pour connecter chacune les émissions lumineuses d'une colonne d'unités électroluminescentes respective, chaque colonne d'émissions lumineuses recevant un courant sensiblement égal en cycle régulier par une ligne de balayage respective,
où une pluralité de lignes de données (DT1, DT2, ... DTn) est prévue pour connecter chacune les unités électroluminescentes d'une rangée d'unités électroluminescentes respective, et est prévue pour commander une durée pendant laquelle une unité électroluminescente spécifique reçoit du courant par une ligne de balayage (SC) spécifique,
où des colonnes d'unités électroluminescentes respectives reçoivent du courant de même intensité en cycle régulier par les lignes de balayage,
où un temps d'alimentation en courant des lignes de balayage est commandé par un temporisateur (54) et du courant n'est pas appliqué simultanément à plus d'une des lignes de balayage, et est appliqué aux lignes de balayage respectives suivant un cycle désigné par le temporisateur (54),
où l'unité électroluminescente cible est commandée de manière à émettre une lumière au niveau de brillance maximal, et les unités électroluminescentes de fond sont commandées de manière à émettre une lumière au niveau de brillance minimal, et
où, quand l'énergie est appliquée, toutes les unités électroluminescentes (57) passent en état de brillance maximale, avant que les unités électroluminescentes restantes, à l'exception de l'unité électroluminescente cible soient progressivement assombries et passent en état de brillance minimale.

2. Procédé de commande selon la revendication 1, où un courant de même intensité est appliqué à la pluralité d'unités électroluminescentes (57) et le cycle de travail de l'unité électroluminescente cible est commandé de manière à être supérieur au cycle de travail des unités électroluminescentes de fond.

3. Procédé de commande selon la revendication 2, où le cycle de travail de l'unité électroluminescente cible est commandé de manière à être supérieur de 4 fois au cycle de travail des unités électroluminescentes de fond.

4. Procédé de commande selon l'une des revendications 1 à 3, où le temporisateur (54) applique du courant aux lignes de balayage (SC) suivant une pluralité de temps d'alimentation en courant.

5. Procédé de commande selon la revendication 4, où la pluralité de temps d'alimentation en courants comprend 1 ms, 875 µs, 750 µs, 625 µs, 500 µs, 375 µs, 250 µs et 125 µs.

6. Procédé de commande selon l'une des revendications 1 à 5, où :
le panneau de commande comprend le contrôleur (53) commandant la machine à traiter des vêtements (100) conformément à une entrée d'instruction de commande par les unités d'entrée (6) ; et
le contrôleur (53) transmet un signal de connexion d'une unité électroluminescente spécifique à une ligne de balayage (SC) spécifique aux unités électroluminescentes respectives par les lignes de données (DT1, DT2, ... DTn).

7. Procédé de commande selon la revendication 6, où le contrôleur (53) :
transmet un signal de connexion de l'unité électroluminescente cible à la ligne de balayage (SC) et de séparation de l'unité électroluminescente cible de la ligne de balayage lors du cycle de travail, de l'unité électroluminescente cible à l'unité électroluminescente cible par les lignes de données (DT1, DT2, ... DTn) ;
transmet un signal de connexion des unités électroluminescentes de fond aux lignes de balayage (SC) et de séparation des unités électroluminescentes de fond des lignes de balayage (SC) lors du de travail des unités électroluminescentes de fond, aux unités électroluminescentes de fond, à l'exception de l'unité électroluminescente cible, par les lignes de données (DT1, DT2, ... DTn).

8. Procédé de commande selon l'une des revendications 1 à 7, où l'unité électroluminescente cible est pré-réglée ou réglée au moyen d'une sélection par un utilisateur par les unités d'entrée (6).

9. Procédé de commande selon la revendication 8, où la pluralité d'unités de dispersion lumineuse (43) affiche des instructions de commande sélectionnables par un utilisateur par les unités d'entrée (6) sur le corps de panneau (4), et une unité électroluminescente (57) correspondant à une instruction de commande sélectionnée par les unités d'entrée (6) est commandée suivant le cycle de travail de l'unité électroluminescente cible.
